Europäisches Patentamt

European Patent Office

Office européen des brevets

(19)

(11) EP 0 656 545 B1

(12) **FASCICULE DE BREVET EUROPEEN**

(45) Date de publication et mention
de la délivrance du brevet:
**30.01.2002 Bulletin 2002/05**

(51) Int Cl.$^7$: **G01R 33/26**

(21) Numéro de dépôt: **94402724.2**

(22) Date de dépôt: **29.11.1994**

(54) **Magnétomètre à polarisation lumineuse et à champ de radiofréquence couplés**

Magnetometer mit polarisiertem Licht und gekoppeltem Hochfrequenzfeld

Magnetometer with polarized light and a coupled radiofrequency field

(84) Etats contractants désignés:
**DE GB IT**

(30) Priorité: **01.12.1993 FR 9314378**

(43) Date de publication de la demande:
**07.06.1995 Bulletin 1995/23**

(73) Titulaire: **COMMISSARIAT A L'ENERGIE ATOMIQUE**
**75015 Paris (FR)**

(72) Inventeurs:
• **Leger, Jean-Michel**
**F-38240 Meylan (FR)**

• **Guttin, Christophe**
**F-38730 Virieu (FR)**

(74) Mandataire: **Dubois-Chabert, Guy**
**BREVATOME 3, rue du Docteur Lanceraux**
**75008 Paris (FR)**

(56) Documents cités:
EP-A- 0 461 999          EP-A- 0 579 537
FR-A- 2 668 862          GB-A- 964 028
US-A- 4 327 327

• OPTICS COMMUNICATIONS, vol.81, no.6, 15 Mars 1991, AMSTERDAM NL pages 369 - 374 H. GILLES ET AL. '4HE OPTICAL PUMPING WITH POLARIZATION MODULATED LIGHT'

## Description

### Domaine technique

La présente invention a pour objet un magnétomètre à polarisation lumineuse et à champ de radiofréquence couplés. Elle trouve une application dans la mesure précise des champs magnétiques faibles (typiquement dans la plage de 20 à 70 µT qui correspond aux valeurs du champ magnétique terrestre).

### Etat de la technique antérieure

Le magnétomètre de l'invention entre dans la catégorie des magnétomètres dits à résonance, dont on pourra trouver une description générale dans l'article de F. Hartman intitulé "Resonance Magnetometers", publié dans la revue IEEE Transactions on Magnetics, vol. MAG-8, n°1, mars 1972, pp. 66-75.

Un magnétomètre à résonance est un appareil qui, plongé dans un champ magnétique $\vec{B}_o$, délivre un signal électrique de fréquence F dont la valeur est liée à Bo par la relation dite de LARMOR :

$$F=\gamma Bo$$

où $\gamma$ est un rapport gyromagnétique d'un électron ou d'un nucléon, selon la substance utilisée. Pour l'électron, par exemple, ce rapport est égal à 28 Hz/nT.

L'excitation de la résonance magnétique est obtenue par un enroulement disposé autour de la substance utilisée. Le prélèvement du signal de résonance s'effectue soit par un autre enroulement (variante électrique) soit par un faisceau lumineux de pompage (variante optique).

L'invention qui va être décrite relève de la seconde variante.

Le document FR-A-2 663 430 décrit un magnétomètre à pompage optique qui est représenté schématiquement sur la figure 1.

Une cellule 10, au moins partiellement transparente, est remplie d'un gaz 12, en général de l'hélium, à une pression de 1 à quelques torrs. Une source lumineuse 14 délivre un faisceau lumineux 15 dont la longueur d'onde se situe autour de 1,1 µm. Ce faisceau traverse un polariseur rectiligne 16. Le faisceau polarisé 17 qui en résulte traverse la cellule 10 et émerge sous forme d'un faisceau 18.

Par ailleurs, une décharge radiofréquence (dite "faible" ou "douce") est produite dans le gaz 12 par un générateur 30 relié à deux électrodes 32, 33 disposées autour de la cellule 10. Cette décharge produit des atomes dans un étant métastable ($2^3S_1$ dans le cas de l'hélium). Le faisceau lumineux incident 17 "pompe" ces atomes à partir de l'état métastable et les amène dans un autre état excité ($2^3P$).

En présence d'un champ magnétique $\vec{B}_o$, les niveaux d'énergie se séparent en sous-niveaux, dits de ZEEMAN. Une résonance entre de tels sous-niveaux peut être établie par un champ radiofréquence.

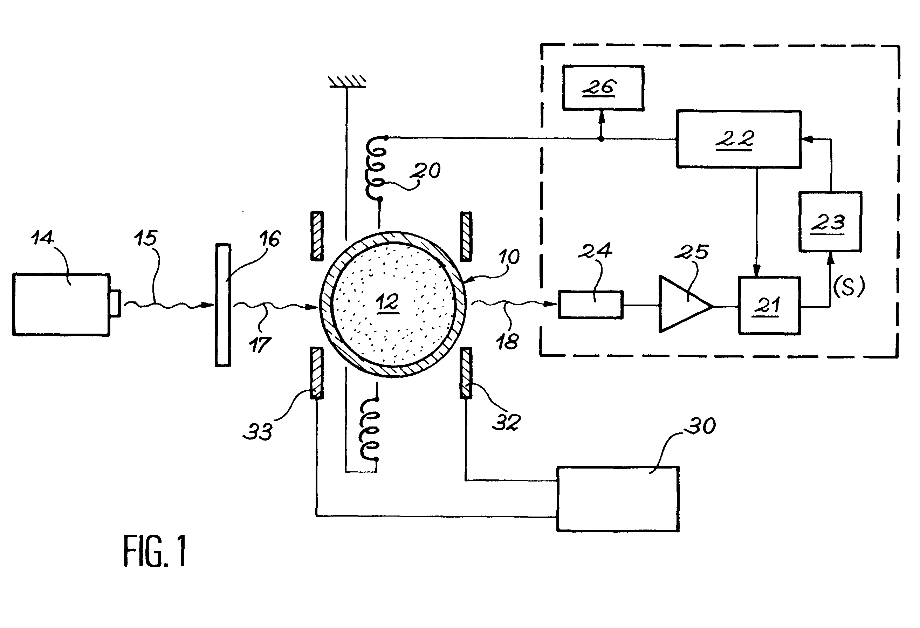

Cette résonance est mise en évidence par divers moyens connus de l'homme du métier, dont une variante est représentée sur la figure 1. Il s'agit d'un enroulement 20 disposé de part et d'autre de la cellule 10 (dans une disposition dite de Helmoltz), d'un générateur radiofréquence 22, d'un photodétecteur 24 recevant le rayonnement lumineux émergent 18, d'un amplificateur 25 relié au photodétecteur 24, d'un détecteur synchrone 21 recevant un signal de référence provenant du générateur 22 et d'un intégrateur 23.

Le générateur 22 alimente l'enroulement 20 en courant à la fréquence F, ce qui crée un champ magnétique oscillant dont une composante entretient la résonance et module en retour le faisceau lumineux 18 ayant traversé la cellule 10. Cette modulation se retrouve dans le signal électrique délivré par le photodétecteur 24 et est détectée par le détecteur synchrone 21. Le signal délivré par le détecteur synchrone 21 possède une composante en phase avec le signal de référence, et cette composante sert de signal d'erreur. L'intégrateur 23 en élimine l'erreur statique. Ce signal d'erreur ajuste la fréquence F du générateur de fréquence 22 pour annuler le signal d'erreur. Ce générateur doit donc pouvoir être commandé en tension. Il peut s'agir par exemple d'un oscillateur commandé en tension (V.C.O. en abrégé pour "Voltage Controlled Oscillator").

Un signal électrique de résonance finit donc par s'établir dans cette boucle et ce signal est à la fréquence de LARMOR. Un fréquencemètre 26 en donne la valeur F. Le champ à mesurer $\vec{B}_o$ s'en déduit par la relation Bo=F/$\gamma$.

Les magnétomètres de ce type ont d'abord utilisé des lampes à hélium. L'obtention récente de cristaux d'aluminate de lanthane-néodyme (ou LNA) ayant permis de réaliser des lasers accordables autour de la longueur d'onde de 1,083 µm correspondant précisément à la raie de pompage optique de l'hélium, ce type de laser s'est substitué tout naturellement à ces lampes avec une amélioration sensible des performances, ce qui a donné un regain d'intérêt à ces magnétomètres.

Un tel magnétomètre, équipé d'un laser à LNA est décrit dans le document FR-A-2 598 518.

Bien que satisfaisants à certains égards, ces magnétomètres présentent cependant des inconvénients. En effet, par principe, ils sont fortement anisotropes, et ceci à la fois en amplitude et en fréquence. Ces anisotropies sont soit des conséquences du cycle de pompage optique et de la détection de l'intensité lumineuse transmise, soit liées au phénomène de résonance magnétique.

Le document FR-A-2 663 430, déjà cité, propose une solution à ce problème. Elle consiste à munir le magnétomètre de moyens permettant de faire tourner la direction de polarisation rectiligne du faisceau lumineux 17 injecté dans la cellule 10, pour lui donner la direction optimale correspondant à une amplitude maximale du signal de résonance.

Plusieurs moyens peuvent être utilisés pour déterminer et obtenir cette direction optimale. Dans une première variante, le magnétomètre comprend un magnétomètre directionnel, comme par exemple un ensemble de trois "flux-gate" ou magnétomètre à RPE (Résonance Paramagnétique Electronique), pour obtenir des informations sur la direction du champ ambiant à mesurer. Un circuit de traitement de ces informations calcule l'orientation optimale de la polarisation et commande, en conséquence, la rotation du polariseur.

Dans une deuxième variante, le magnétomètre comprend des moyens pour moduler à basse fréquence la direction de polarisation et pour effectuer une détection synchrone du signal de résonance. Le signal détecté sert de signal d'erreur pour corriger la polarisation et lui donner la direction optimale.

Bien que donnant satisfaction à certains égards, ces solutions présentent l'inconvénient de la complexité, surtout dans la variante à flux-gates associés. La variante à modulation de polarisation présente en outre l'inconvénient de réduire la bande passante du magnétomètre, puisque la fréquence maximale d'analyse est nécessairement inférieure à celle de la modulation.

Une solution à ces problèmes a été proposée dans la demande EP-A-0579537 (date de publication 19.01.94) intitulée "Magnétomètre à polarisation lumineuse et à champ de radiofréquence asservis". Cette demande présente un magnétomètre sans anisotropie (de fréquence ou d'amplitude) et qui ne fait pas appel à une modulation de la polarisation lumineuse ou à des magnétomètres directionnels associés. Ce résultat est obtenu en asservissant en direction la polarisation P du faisceau lumineux incident dans une direction perpendiculaire au champ magnétique ambiant $\vec{B}_o$ à mesurer et, simultanément, en asservissant la direction du champ magnétique radiofréquence $\vec{B}_1$ parallèlement à la direction de polarisation $\vec{P}$. En d'autres termes, la direction de polarisation $\vec{P}$ ainsi que celle du champ radiofréquence $\vec{B}_1$ se trouvent toutes deux orientées dans la même direction optimale et ce, quelle que soit la direction du champ magnétique à mesurer.

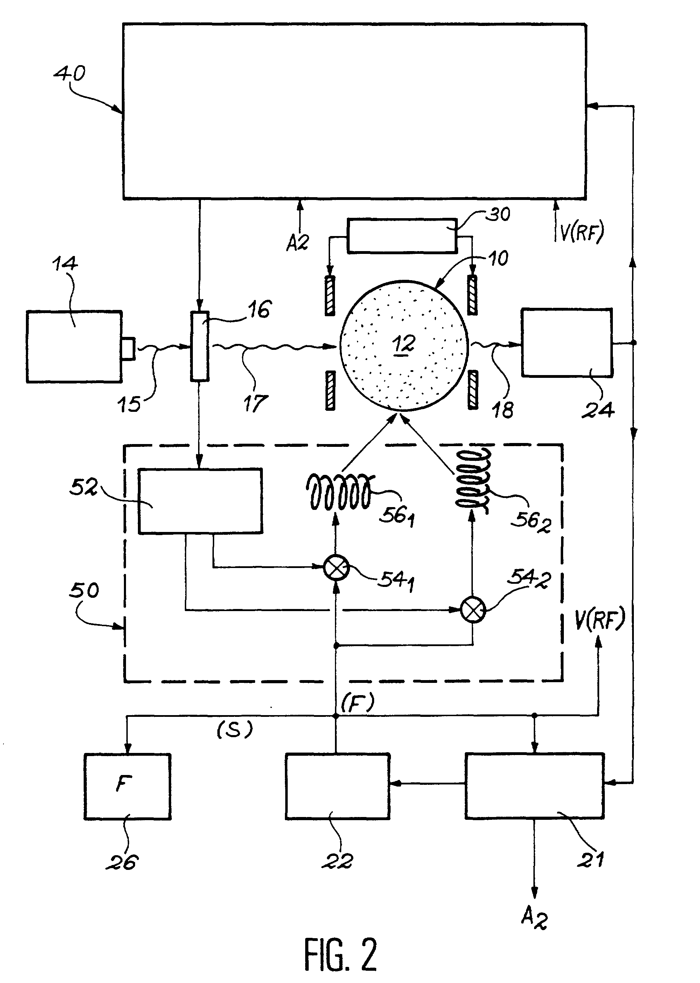

Ce type de magnétomètre est illustré sur la figure 2 qui comprend des moyens déjà représentés sur la figure 1 et qui portent pour cette raison les mêmes références : il s'agit de la cellule 10 remplie de gaz 12, du laser 14 émettant un faisceau 15, du polariseur 16 délivrant un faisceau à polarisation rectiligne 17, du photodétecteur 24 recevant le faisceau émergeant 18, du circuit d'asservissement de fréquence 21, du générateur de radiofréquence 22, du fréquencemètre 26 et du circuit de décharge 30.

Ce magnétomètre comporte en outre un premier circuit d'asservissement 40 qui pilote la position angulaire $\theta$ du polariseur.

Il comporte aussi un circuit d'asservissement 50 du champ de radiofréquence $\vec{B}_1$ qui comprend :

- un système de mesure et de codage de l'angle $\theta$ de polarisation 52,
- deux multiplieurs $54_1$, $54_2$ recevant, d'une part, ces signaux et, d'autre part, le signal radiofréquence délivré par le générateur 22,
- deux enroulements $56_1$, $56_2$ à axes orthogonaux auxquels sont connectées les sorties des deux multiplieurs $54_1$ et $54_2$.

En injectant, dans les enroulements des courants $i_1 = i\cos\theta$ et $i_2 = i\sin\theta$, on peut ajuster la direction de $\vec{B}_1$ sur celle de la polarisation $\vec{P}$.

Ce montage génère plusieurs types d'erreurs qui modifient ou affectent l'angle $(\vec{P}, \vec{B}_1)$ que l'on souhaiterait, au contraire, maintenir constant et égal à $0°$ puisque, lorsque les deux directions $\vec{P}$ et $\vec{B}_1$ sont perpendiculaire à $\vec{B}_o$, un fonctionnement optimum du magnétomètre est assuré. Ces erreurs proviennent :

1. d'erreurs au cours du codage de l'angle $\theta$ (par le système (52), voir figure 2). En fait, il faudrait une précision du codeur de l'ordre du millidegré, ce qui est irréaliste parce que trop complexe à réaliser,
2. d'erreur sur l'orthogonalité des bobines 561 et 562 qu'il faudrait pouvoir maintenir strictement perpendiculaires,
3. d'erreurs ou de variations des fonctions de transfert courant fourni aux bobines/champ engendré par les bobines.

Or, il a été constaté que des modifications de l'angle $(\vec{P}, \vec{B}_1)$ se traduisent par des variations de la phase du signal de résonance utilisé pour mesurer la fréquence de LARMOR.

Ainsi, d'une variation de cette phase de un degré, il résulte un décalage de fréquence du magnétomètre de l'ordre du nanotesla alors que la sensibilité à atteindre est de l'ordre du picotesla.

Le magnétomètre proposé par cette demande FR-92 08783, quoique satisfaisante à certains égards, n'en comporte donc pas moins certains désavantages.

## Exposé de l'invention

La présente invention a justement pour but de remédier aux inconvénients qui ont été exposés ci-dessus. A cette fin, elle prévoit un magnétomètre sans anisotropie (de fréquence ou d'amplitude) et qui ne fait pas appel à une modulation de la polarisation lumineuse ou à des magnétomètres directionnels associés. Ce résultat est obtenu en asservissant en direction de la polarisation du faisceau lumineux incident dans une direction perpendiculaire au champ magnétique ambiant Bo à mesurer et, simultanément, en asservissant la direction du champ magnétique radiofréquence parallèlement à la direction de polarisation. En d'autres termes, la direction de polarisation ainsi que celle du champ radiofréquence se trouvent toutes deux orientées dans la même direction optimale et ce, quelle que soit la direction du champ magnétique à mesurer.

De façon plus précise, la présente invention a pour objet un magnétomètre à résonance et à pompage optique comprenant une cellule remplie d'un gaz dont les atomes présentent un rapport gyromagnétique $\gamma$, cette cellule plongeant dans un champ magnétique ambiant $\vec{B}_o$ qui est le champ à mesurer, une source lumineuse émettant un faisceau lumineux, un polariseur rectiligne traversé par ce faisceau et donnant à ce faisceau une polarisation rectiligne selon une première direction, le faisceau polarisé rectilignement traversant ensuite la cellule, un photodétecteur recevant le faisceau lumineux ayant traversé la cellule, ce photorécepteur délivrant un signal électrique, des moyens pour appliquer un champ radiofréquence $\vec{B}_1$ à la cellule, ce champ ayant une seconde direction et une certaine fréquence, des moyens pour asservir cette fréquence à la fréquence de LARMOR F=$\gamma$Bo, un moyen pour mesurer cette fréquence, l'amplitude du champ magnétique ambiant $\vec{B}_o$ se déduisant de la fréquence F par la relation Bo=F/$\gamma$,

ce magnétomètre étant caractérisé par le fait qu'il comprend en outre :

- des moyens de solidarisation mécanique solidarisant mécaniquement avec le polariseur les moyens pour appliquer le champ radiofréquence $\vec{B}_1$,
- des moyens d'asservissement agissant sur les moyens de solidarisation mécanique, ces moyens comprenant un circuit de détection synchrone recevant le signal électrique délivré par le photodétecteur et un signal de référence ($V_{RF}$) à la fréquence F du champ radiofréquence, le signal électrique comprenant deux composantes $A_1$ et $A_2$ respectivement à la fréquence de Larmor et la fréquence double de celle de Larmor, le circuit détectant l'amplitude $|A_{1q}|$ de la composante $A_1$ à la fréquence de Larmor F, en quadrature de phase avec le signal de référence ($V_{RF}$), cette amplitude servant à commander des moyens pour faire tourner les moyens de solidarisation mécanique de sorte que, par conséquent, le polariseur et les moyens pour appliquer le champ radiofréquence sont tournés simultanément.

L'invention telle que définie ci-dessus possède l'avantage d'une simplicité considérable par rapport au magnétomètre décrit dans le document FR-A-2 663 430.

En effet, elle ne fait appel ni à une modulation de la polarisation lumineuse, ni à un magnétomètre directionnel associé.

Par rapport à la solution qui a été proposée dans la demande FR-92 08783, on élimine toute source possible d'erreur liée soit au codage de la rotation angulaire du polariseur, et à sa transmission aux bobines, ainsi que toute autre source d'erreur entraînant des variations de phase sur les signaux détectés. En effet, dans la présente invention, le polariseur et les moyens générateurs du champ de radiofréquence sont solidaires l'un de l'autre et la rotation de ces éléments est simultanée ; on est donc sûr que le même angle, de préférence O°, sera conservé entre la direction de polarisation, d'une part, et la direction du champ $\vec{B}_1$ de radiofréquence d'autre part.

Il en découle une erreur de phase qui est sans conséquence pour le magnétomètre dans la mesure où seules les variations du champ magnétique - et non sa valeur absolue - sont intéressantes.

De préférence, ce magnétomètre sera de plus caractérisé en ce que le circuit de détection synchrone vérifie que l'amplitude ($A_2$) du signal à la fréquence double n'est pas nulle et en ce que la direction de polarisation rectiligne du faisceau est parallèle à la direction du champ de radiofréquence.

Selon un autre mode de réalisation particulier, un magnétomètre selon l'invention sera de plus caractérisé en ce que les moyens générateurs de radiofréquence sont constitués d'une bobine unique.

L'utilisation d'une bobine unique apporte encore une simplification par rapport au document FR-A-2 663 430 puisqu'un mode de réalisation d'un magnétomètre y avait été proposé, où trois enroulements d'excitation étaient disposés autour de la cellule, ces enroulements étant mis en service séquentiellement par rapport à un multiplexeur.

Enfin, selon un autre mode de réalisation particulier, le magnétomètre selon l'invention sera caractérisé en ce que les moyens pour faire tourner l'ensemble polariseur-moyens pour appliquer le champ de radiofréquence sont constitués par un moteur piézoélectrique.

Le choix d'un moteur piézoélectrique a été guidé par le fait qu'il fallait trouver un moteur à la fois suffisamment puissant pour faire tourner l'ensemble polariseur-bobines de radiofréquence tout en respectant des contraintes très restrictives d'amagnétisme.

De toute façon, les caractéristiques et avantages de l'invention apparaîtront mieux à la lumière de la description qui va suivre. Cette description porte sur des exemples de réalisation, donnés à titre explicatif et non limitatif. Elle se réfère par ailleurs à des dessins annexés sur lesquels :

- la figure 1, déjà décrite, montre un magnétomètre de l'art antérieur,
- la figure 2, déjà décrite, montre un mode de réalisation d'un magnétomètre selon l'art antérieur,
- la figure 3 représente un mode de réalisation d'un magnétomètre selon l'invention,
- la figure 4 représente le montage polariseur-bobine dans un magnétomètre selon l'invention,
- les figures 5a et 5b représentent les composantes, en phase et en quadrature avec la tension de référence, du signal à fréquence égale à deux fois la fréquence de LARMOR,

- la figure 6 représente un moteur piézoélectrique pour un magnétomètre selon l'invention,
- la figure 7 est un schéma montrant l'orientation relative du champ $\vec{B}_o$ et de la polarisation $\vec{P}$,
- les figures 8a, 8b, 8c, 8d montrent les variations de l'amplitude de divers signaux en fonction de l'angle que fait la direction de polarisation $\vec{P}$ avec le champ magnétique ambiant $\vec{B}_o$.

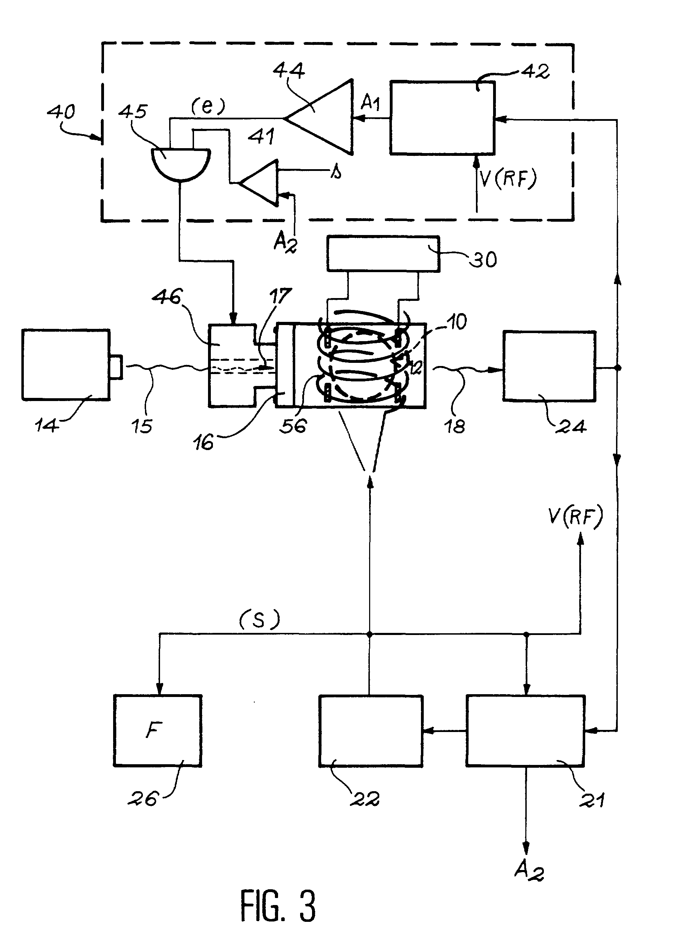

Un magnétomètre selon un mode préféré de réalisation de l'invention est représenté sur la figure 3. Ce magnétomètre comporte des moyens déjà représentés sur les figures 1 et 2 et qui portent pour cette raison les mêmes références. Il s'agit de la cellule 10 remplie de gaz 12, du laser 14 émettant un faisceau 15, du polariseur 16 délivrant un faisceau polarisé rectiligne 17, du photodétecteur 24 recevant le faisceau émergeant 18, du circuit d'asservissement de fréquence 21, du générateur de radiofréquence 22, du fréquencemètre 26 et du circuit de décharge 30. Le générateur 22 pilote le courant induit dans une bobine 56 placée à proximité de la cellule 12 de façon à engendrer dans cette dernière un champ de radiofréquence $\vec{B}_1$. La bobine 56 et le polariseur 16 sont solidarisés mécaniquement, de telle façon que toute rotation d'angle θ appliquée au polariseur entraîne une rotation du même angle de la direction du champ $\vec{B}_1$, l'intensité de ce dernier étant définie par le générateur 22. Avantageusement, pour relier les moyens 56 et 22, on utilise un contact tournant, par exemple un contact par couplage capacitif ou par un transformateur dont l'enroulement primaire est fixe et l'enroulement secondaire mobile.

De préférence, la bobine et le polariseur sont montés de façon à ce que la polarisation $\vec{P}$ et le champ $\vec{B}_1$ soient parallèles.

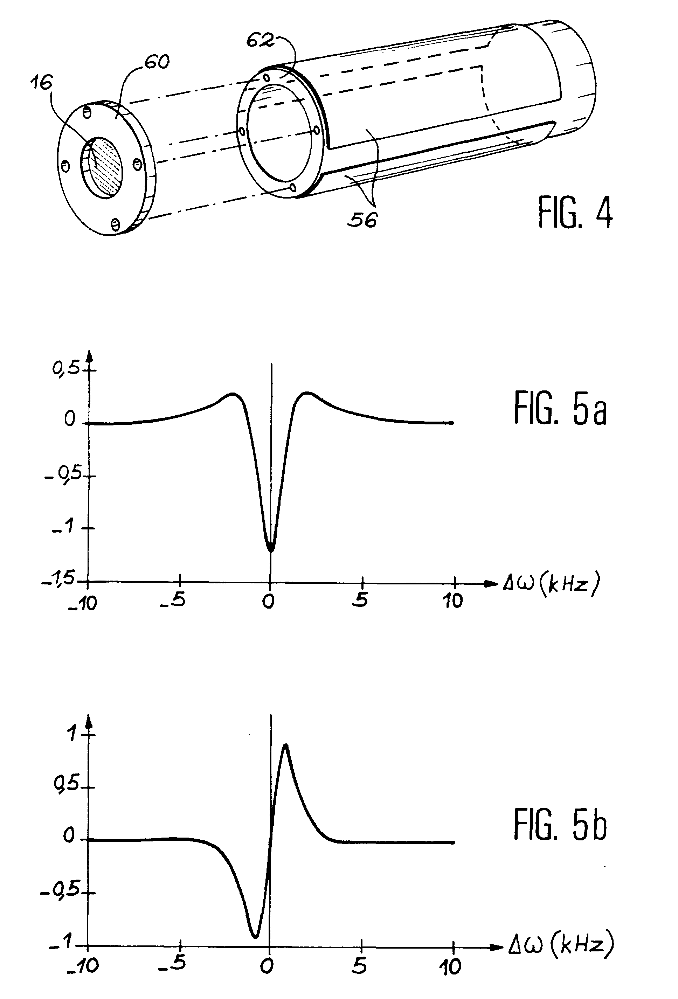

Le montage bobine-polariseur est plus précisément illustré sur la figure 4. Le polariseur 16 est monté au centre d'un support en anneau 60, évidé dans sa partie centrale. La bobine 56 est montée sur un cylindre creux 62. Pour solidariser les deux, il suffit de monter l'anneau au bout du cylindre, par exemple avec des vis amagnétiques.

Il faut noter que le signal détecté par le photodétecteur 24 comprend, outre une composante continue $A_O$, deux composantes $A_1$ et $A_2$, respectivement à la fréquence de LARMOR et à la fréquence double de celle de LARMOR. De plus, chaque composante $A_1$ et $A_2$ est complexe et il est commode de les représenter par leur composante en phase et en quadrature de phase avec un signal de référence $V_{RF}$ à la fréquence de LARMOR engendré par le générateur 22. Ainsi, on a représenté sur les figures 5a et 5b les composantes en phase et en quadrature de phase de $A_2$ (terme à la fréquence double de celle de LARMOR) en fonction de l'écart de la fréquence d'excitation ω par rapport à la fréquence de LARMOR.

On remarque que la composante en quadrature possède une partie centrale antisymétrique et quasiment linéaire.

Aucune variation de phase due à une variation de l'angle $(\vec{P},\vec{B}_1)$ ne peut influer sur l'amplitude de la composante de $A_1$ en quadrature avec la tension de référence, qui est détectée par le circuit 42 : en effet, du fait de la solidarisation polariseur-bobine, un angle constant, de préférence nul, est maintenu entre $\vec{P}$ et $\vec{B}_1$. Or, c'est la variation de cet angle qui entraînerait en l'absence de solidarisation, une variation des phases de $A_1$ et $A_2$.

Le moteur 46 avec lequel on commande le polariseur 16 sera un moteur suffisamment puissant pour pouvoir effectuer une rotation de l'ensemble polariseur-bobine-moyens de solidarisation. Mais il faut, d'autre part, respecter des contraintes très restrictives d'amagnétisme. En effet, une des spécifications du magnétomètre est que la mesure du champ magnétique doit être indépendante de l'orientation du capteur par rapport à ce champ. Il est donc fondamental de ne ramener aucun élement magnétique ou nécessitant une alimentation par courant continu à proximité de la sonde, puisque de tels composants généreraient lors de rotations de la sonde des signatures magnétiques et donc des erreurs de mesure du champ terrestre dont l'importance varierait selon la disposition du magnétomètre.

Compte tenu de ces contraintes, un moteur de type piézoélectrique a été choisi.

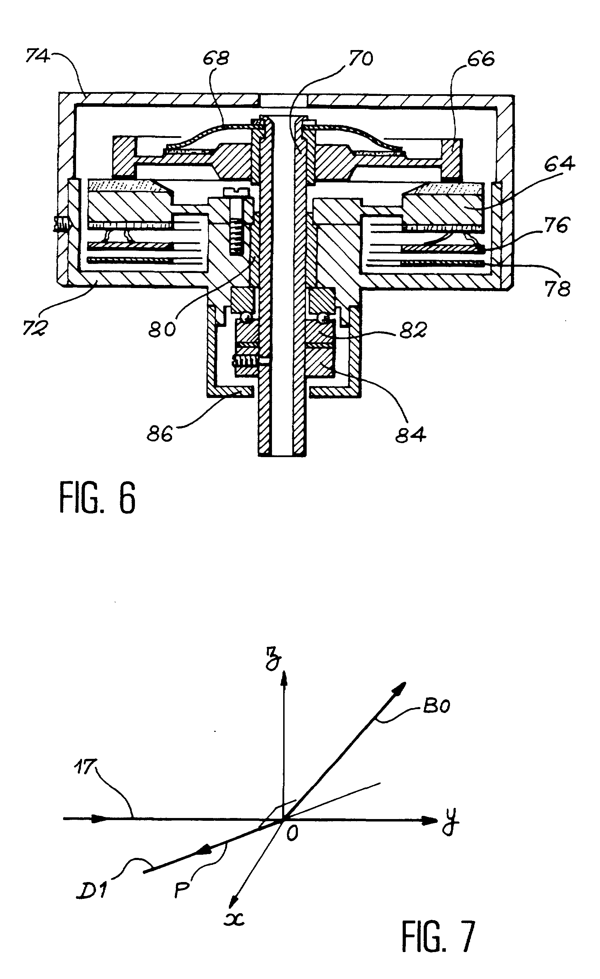

Plus précisément, le moteur piézoélectrique réalisé est illustré sur la figure 6. Le fonctionnement de ce type de moteur repose sur l'exploitation des mouvements générés à la surface d'un stator qui se présente sous la forme d'un corps "élastique" excité en vibrations. Un rotor 66 plaqué contre le stator par le biais d'un ressort 68 est entraîné par frottements par le stator. Pour l'invention, l'ensemble du moteur 46 a été réalisé avec un axe creux 70 afin de permettre la transmission du faisceau lumineux à travers le dispositif. Le rotor 66 et le stator 64 sont tous deux annulaires et le support mécanique 16 et les moyens 56 d'excitation du champ de radiofréquence, est solidarisé au moteur par l'intermédiaire de l'axe de ce dernier. Le support mécanique 60, 62 est ainsi mis en rotation par le moteur 46, le contrôle de la vitesse et du sens de rotation du rotor 66 se faisant par le biais de l'excitation électrique appliquée à un transducteur piézoélectrique utilisé pour créer à la surface du stator 64 l'onde progressive qui est à l'origine des déplacements angulaires du rotor. Sur la figure 6, les références 72 et 74 représentent respectivement un boîtier et son couvercle, la référence 76 une platine, la référence 78 un caoutchouc de protection. L'axe 70 passe dans un palier 80. L'ensemble est compris entre le ressort 68 et une butée en céramique 82, la référence 84 représentant une bague d'appui et la référence 86 une protection de la butée.

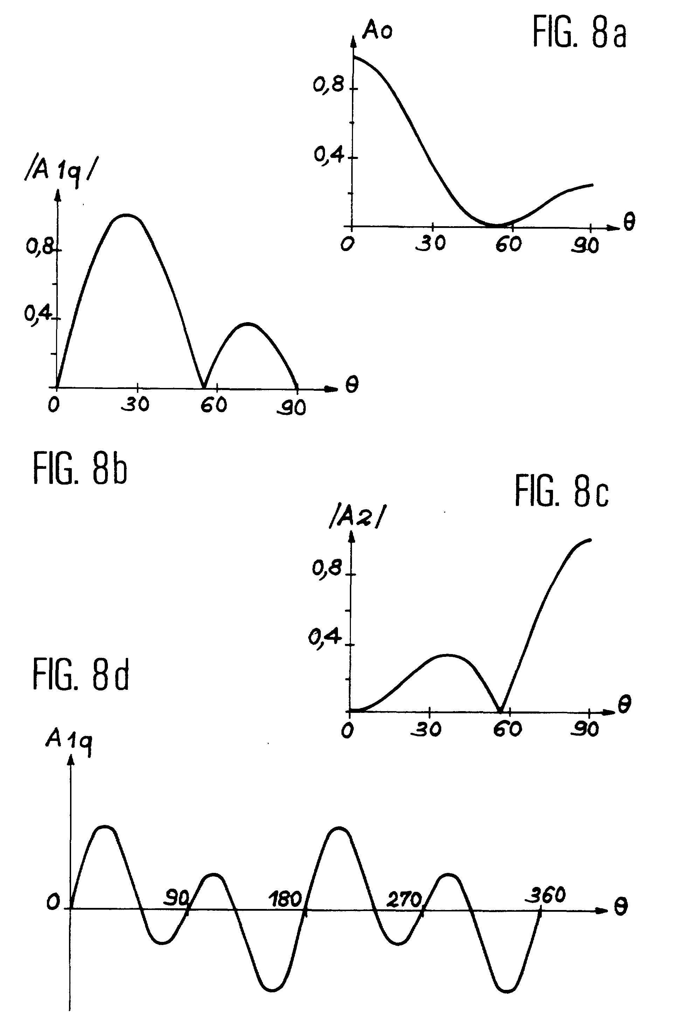

Le magnétomètre comprend un circuit 40 d'asservissement de la direction du polariseur 16. Ce circuit comprend un premier circuit de détection synchrone 42 recevant le signal électrique délivré par le photodétecteur 24 et une tension de référence $V_{RF}$ provenant du générateur 22. Ce circuit 42 détecte l'amplitude $A_{1q}$ de la composante en quadrature de phase avec le signal de référence $V_{RF}$. Pour des raisons qui apparaîtront mieux en liaison avec la figure 8d, cette amplitude A1q sert de signal d'erreur, lequel, une fois amplifié par un amplificateur 44, alimente le moteur 46 qui fait tourner le polariseur 16 dans un sens tel que le signal d'erreur s'annule. La rotation du polariseur 16 entraîne, du fait de la solidarisation mécanique polariseur-bobine, la rotation de la bobine 56.

La figure 7 permet d'illustrer la fonction remplie par l'asservissement 40. Les directions sont repérées par rapport à un système d'axes trirectangles Oxyz. Le faisceau lumineux 17 est censé se propager le long de l'axe Oy. La polarisation rectiligne $\vec{P}$ de ce faisceau est donc situé dans le plan xOz. Le champ magnétique ambiant $\vec{B}_0$ est dirigé dans une direction quelconque. Les moyens d'asservissement 40 ont alors pour fonction de donner à la polarisation la direction $D_1$ perpendiculaire à Bo.

Le champ de radiofréquence $\vec{B}_1$ est supposé orienté parallèlement à D1, du fait de la solidarisation mécanique polariseur-bobine. Lorsque la polarisation $\vec{P}$ est perpendiculaire à $\vec{B}_0$, $\vec{B}_1$ est donc lui aussi perpendiculaire à $\vec{B}_0$. On observera que, quelle que soit la direction de $\vec{B}_0$, il existe toujours une direction du plan xOz qui est perpendiculaire à $\vec{B}_0$. Or, il est certain qu'au cours d'une rotation complète du polariseur 16, la direction de polarisation $\vec{P}$ passera par une position à 90° de $\vec{B}_0$. En effet, l'angle minimum que fait $\vec{B}_0$ avec une droite du plan xOz est égal à $(\pi/2)-\theta n$ si $\theta n$ désigne l'angle que fait la normale au plan xOz (autrement dit l'axe Oy) avec le champ $\vec{B}_0$ ; l'angle maximum est égal à $(\pi/2)+\theta n$. Lors d'une rotation de 360° du polariseur, l'angle que fait la direction de polarisation $\vec{P}$ avec $\vec{B}_0$ variera donc entre $(\pi/2)-\theta n$ et $(\pi/2)+\theta n$. Il passera donc forcément par $\pi/2$.

Rappelons que le signal détecté par le photodétecteur 14 comporte, outre un terme continu $A_o$, des composantes spectrales $A_1$ et $A_2$ respectivement à la fréquence de LARMOR et à la fréquence double de celle de LARMOR.

Les figures 8a à 8d montrent les variations de certains signaux en fonction de l'angle $\theta$ que fait la direction de polarisation avec la direction du champ magnétique à mesurer $\vec{B}_0$.

Sur la figure 8a, l'amplitude $A_o$ est l'amplitude de la composante continue du signal. Cette composante est en $(3\cos^2\theta-1)^2$. Cette composante est nulle pour un angle d'environ 54°. Elle est maximum pour $\theta=90°$ et 0° (si $\theta=90°$ peut toujours être atteint, comme expliqué plus haut, ce n'est pas toujours le cas pour la valeur 0 qui ne peut être atteinte que si Bo est dans le plan xOz).

La figure 8b montre la valeur absolue $|A_{1q}|$ de l'amplitude de la composante à la fréquence de LARMOR et en quadrature de phase avec le signal de radiofréquence. Cette composante est en $|\sin^2\theta(3\cos^2\theta-1|$. Elle s'annule pour $\theta=0$ et 90° et également pour 54°.

La figure 8c montre la valeur absolue $|A_2|$ de l'amplitude de la composante à la fréquence double de la fréquence de LARMOR. Cette composante est en $|\sin^2\theta(1-3\cos^2\theta)|$. Elle s'annule pour $\theta=0$ et 54° et passe par un maximum pour $\theta=90°$.

Enfin, la figure 8d montre l'amplitude $A_{1q}$, en grandeur et en signe, qui est le signal d'asservissement destiné au circuit 42.

On voit que le signa A1q à la fréquence de LARMOR, par son annulation et son changement de signe pour $\theta=90°$, constitue un signal d'erreur commode permettant d'obtenir un asservissement de la direction de polarisation à 90° du champ $\vec{B}_0$. Mais ce signal s'annule également pour les angles 0 et 54° de sorte qu'il y a un risque de voir la direction de polarisation s'accrocher sur ces valeurs intempestives. Pour éviter ce risque, on utilisera conjointement le fait que le signal à fréquence double (figure 8c) présente un maximum pour $\theta=90°$, ce qui permet de distinguer cette valeur des deux autres (0 et 54°) où $|A_2|$ est nul. Il n'est d'ailleurs pas nécessaire de s'assurer que le signal $|A_2|$ est maximum. Il suffit de vérifier qu'il n'est pas nul, c'est-à-dire, en pratique, qu'il excède un certain seuil.

L'asservissement de polarisation s'effectue donc en vérifiant que deux conditions sont simultanément satisfaites, à savoir $A_{1q}$ nul et $A_2$ supérieur à un certain seuil. Cette double fonction est assurée dans le circuit 40, par exemple par un comparateur 41 qui compare $A_2$ à un seuil s et par une porte logique Et 45 qui ne délivre un signal de commande au moteur 46 que si $A_2$ est supérieur au seuil.

Cette propriété du signal à la fréquence double peut n'être exploitée qu'à la mise en route du magnétomètre pour accrocher la polarisation $\vec{P}$ à la valeur 90°. Ensuite, si le champ $\vec{B}_0$ change de direction, la polarisation restera asservie à la bonne direction.

Dès lors qu'il est fait usage du signal $A_2$ à fréquence double, il est avantageux d'exploiter ce même signal pour asservir en fréquence le magnétomètre et cela par les moyens 21 qui viennent piloter le générateur 22. De préférence, on emploiera, pour cela, la composante de $A_2$ en quadrature (celle représentée sur la figure 5b) par rapport au signal de référence : sa partie centrale, antisymétrique et linéaire, se prête à ce type de mesure. En outre, aucune variation de phase due à une variation de l'angle $(\vec{P},\vec{B}_1)$ ne peut influer sur cette composante puisque, justement $\vec{P},\vec{B}_1$ sont maintenus parallèles par la solidarisation mécanique polariseur-bobine.

Le circuit 21 peut aussi délivrer un signal reflétant l'amplitude $|A_2|$ de la composante à la fréquence double, à destination du comparateur 41 qui exploitera cette information pour valider le signal d'erreur $A_{1q}$, par l'intermédiaire du comparateur 41.

## Revendications

1. Magnétomètre à résonance et à pompage optique comprenant une cellule (10) remplie d'un gaz (12) dont les atomes présentent un rapport gyromagnétique $\gamma$, cette cellule plongeant dans un champ magnétique ambiant $\vec{B}_o$ qui est le champ à mesurer, une source lumineuse (14) émettant un faisceau lumineux (15), un polariseur rectiligne (16) traversé par ce faisceau (15) et donnant à ce faisceau une polarisation rectiligne selon une première direction ($D_1$), le faisceau polarisé rectilignement (17) traversant ensuite la cellule (10), un photodétecteur (24) recevant le faisceau lumineux (18) ayant traversé la cellule (10), ce photorécepteur (24) délivrant un signal électrique, des moyens (56) pour appliquer un champ radiofréquence ($\vec{B}_1$) à la cellule (10), ce champ ayant une seconde direction ($D_2$) et une certaine fréquence, des moyens (21, 22) pour asservir cette fréquence à la fréquence de Larmor F=$\gamma$Bo, un moyen (26) pour mesurer cette fréquence (F), l'amplitude du champ magnétique ambiant $\vec{B}_o$ se déduisant de la fréquence (F) par la relation Bo=F/$\gamma$, ce magnétomètre étant **caractérisé par le fait qu'**il comprend en outre :

   - des moyens de solidarisation mécanique solidarisant mécaniquement avec le polariseur (16) les moyens (56) pour appliquer le champ radiofréquence ($B_1$),
   - des moyens d'asservissement (40) agissant sur les moyens de solidarisation mécanique, ces moyens comprenant un circuit de détection synchrone (42) recevant le signal électrique délivré par le photodétecteur (24) et un signal de référence ($V_{RF}$) à la fréquence F du champ radiofréquence, le signal électrique comprenant deux composantes $A_1$ et $A_2$ respectivement à la fréquence de Larmor et la fréquence double de celle de Larmor, le circuit (42) détectant l'amplitude $|A_{1q}|$ de la composante $A_1$ à la fréquence de Larmor (F), en quadrature de phase avec le signal de référence ($V_{RF}$), cette amplitude servant à commander des moyens (46) pour faire tourner les moyens de solidarisation mécanique de sorte que, par conséquent, le polariseur (16) et les moyens (56) pour appliquer le champ radiofréquence sont tournés simultanément.

2. Magnétomètre selon la revendication 1, **caractérisé en ce que** l'amplitude $|A_2|$ du signal à la fréquence double de la fréquence de Larmor n'est pas nulle, et **en ce que** la direction (D1) de polarisation rectiligne du faisceau (15) est parallèle à la direction (D2) du champ radiofréquence ($\vec{B}_1$).

3. Magnétomètre selon l'une des revendications 1 ou 2, **caractérisé en ce que** les moyens générateurs de radiofréquence (56) sont constitués d'une bobine unique.

4. Magnétomètre selon l'une quelconque des revendications 1 à 3, **caractérisé en ce que** les moyens (46) pour faire tourner l'ensemble polariseur-moyens générateurs du champ de radiofréquence (56) sont constitués par un moteur piézo-électrique.

## Patentansprüche

1. Optisch gepumptes Resonanzmagnetometer, umfassend eine Zelle (10), gefüllt mit einem Gas (12), dessen Atome ein gyromagnetisches Verhältnis $\gamma$ aufweisen, wobei diese Zelle in ein magnetisches Umgebungsfeld $\vec{B}_0$ eingetaucht ist, das das zu messende Feld ist, eine einen Lichtstrahl (15) aussendende Lichtquelle (14), einen Linearpolarisator (16), der von diesem Strahl (15) durchquert wird und diesem Strahl eine lineare Polarisation entsprechend einer ersten Richtung ($D_1$) verleiht, wobei der linear polarisierte Strahl (17) anschließend die Zelle (10) durchquert, einen Photodetektor (24), der den Strahl (18) empfängt, nach erfolgter Durchquerung der Zelle (10), wobei dieser Photorezeptor (24) ein elektrisches Signal liefert, Einrichtungen (56), um auf die Zelle (10) ein Radiofrequenzfeld ($\vec{B}_1$) anzuwenden, wobei dieses Feld eine zweite Richtung ($D_2$) und eine bestimmte Frequenz hat, Einrichtungen (21, 22), um diese Frequenz auf die Larmor-Frequenz F=$\gamma$Bo zu regeln, eine Einrichtung (26), um diese Frequenz (F) zu messen, wobei die Amplitude des Umgebungsmagnetfelds $\vec{B}_0$ sich durch die Relation Bo=F/$\gamma$ von der Frequenz (F) ableitet, wobei dieses Magnetometer **dadurch gekennzeichnet ist, dass** es außerdem umfasst:

   - mechanische Verbindungseinrichtungen, die die Einrichtungen (56) zur Anwendung des Radiofrequenzfelds ($\vec{B}_1$) mit dem Polarisator (16) verbinden,
   - Regeleinrichtungen (40), die auf die mechanischen Verbindungseinrichtungen wirken, wobei diese Einrichtungen eine Synchrondetektionsschaltung (42) umfassen, die das durch den Photodetektor (24) geliefertes elektrische Signal und ein Referenzsignal ($V_{RF}$) mit der Frequenz F des Radiofrequenzfelds empfangen, wobei das elektrische Signal zwei Komponenten $A_1$ und $A_2$ mit jeweils der Larmorfrequenz und der doppelten Frequenz dieser Larmorfrequenz umfasst, diese Schaltung (42) die Amplitude $|A_{1q}|$ der Komponente $A_1$ mit der Larmorfrequenz (F) detektiert, die zum Referenzsignal ($V_{RF}$) um 90° phasenverschoben ist, wobei diese Amplitude dazu dient, Einrichtungen (46) zu steuern, um die mechanischen Verbindungseinrichtungen so zu drehen, dass infolgedessen der Polarisator (16) und die Einrichtungen (56) zur Anwendung des Radiofrequenzfeldes simultan gedreht werden.

2. Magnetometer nach Anspruch 1, **dadurch gekennzeichnet, dass** die Amplitude $|A_2|$ des Signals mit der doppelten Frequenz der Larmorfrequenz nicht gleich null ist, und dass die Richtung (D1) der Linearpolarisation des Strahls (15) parallel zu der Richtung (D2) des Radiofrequenzfelds ($\vec{B}_1$) ist.

3. Magnetometer nach einem der Ansprüche 1 oder 2, **dadurch gekennzeichnet, dass** die Radiofrequenz-Erzeugungseinrichtungen (56) durch eine einzige Spule gebildet werden.

4. Magnetometer nach einem der Ansprüche 1 bis 3, **dadurch gekennzeichnet, dass** die Einrichtungen (46) zum Drehen der Einheit aus Polarisator und Radiofrequenz-Erzeugungseinrichtungen (56) durch einen piezoelektrischen Motor gebildet werden.

## Claims

1. Optical pumping, resonance magnetometer comprising a cell (10) filled with a gas (12), whereof the atoms have a gyromagnetic ratio $\gamma$, said cell being placed in an ambient magnetic field (Bo), which is the field to be measured, a light source (14) emitting a light beam (15), a linear polarizer (16) through which said beam (15) passes and giving said beam a linear polarization in a first direction ($D_1$), the linearly polarized beam (17) then passing through the cell (10), a photodetector (24) receiving the light beam (18) which has passed through the cell (10), said photodetector (24) supplying an electric signal, means (56) for applying a radio frequency field ($B_1$) to the cell (10), said field having a second direction ($D_2$) and a certain frequency, means (21, 22) for coupling said frequency to the Larmor frequency F = $\gamma$Bo, a means (26) for measuring said frequency (F), the amplitude of the ambient magnetic field (Bo) being deduced from the frequency (F) by the relation Bo = F/$\gamma$, said magnetometer also being **characterized in that** it comprises means for mechanically joining to the polarizer (16) the means (56) for applying the radio frequency field ($B_1$) to the cell and coupling means (40) acting on the mechanical joining means, said means having a synchronous detection circuit (42) receiving the electric signal supplied by the photodetector (24) and a reference signal ($V_{RF}$) at the frequency F of the radio frequency field, the electric signal comprising two components $A_1$ and $A_2$ respectively at the Larmor frequency and double the Larmor frequency, the circuit (42) detecting the amplitude $|A_{1q}|$ of the components A1 at the Larmor frequency (F), in phase quadrature with the reference signal ($V_{RF}$), said amplitude being used for controlling means (46) for rotating the mechanical joining means in such a way that as a consequence the polarizer (16) and means (56) for applying the radio frequency field are simultaneously rotated.

2. Magnetometer according to claim 1, **characterized in that** the amplitude |A2| of the signal at twice the Larmor frequency is not zero and **in that** the rectilinear polarization direction (D1) of the beam (15) is parallel to the direction (D2) of the radio frequency field ($\vec{B}_1$).

3. Magnetometer according to one of the claims 1 or 2, **characterized in that** the radio frequency generating means (56) are constituted by a single coil.

4. Magnetometer according to any one of the claims 1 to 3, **characterized in that** the means (46) for rotating the assembly constituted by the polarizer and the radio frequency field generating means (56) are constituted by a piezoelectric motor.

FIG. 1

EP 0 656 545 B1

FIG. 2

10

FIG. 3

FIG. 4

FIG. 5a

FIG. 5b

FIG. 6

FIG. 7

FIG. 8a

FIG. 8b

FIG. 8c

FIG. 8d